# EUROPÄISCHE PATENTSCHRIFT

(11) **EP 3 210 214 B1**
(45) Veröffentlichungstag und Bekanntmachung des Hinweises auf die Patenterteilung: **01.09.2021**
(21) Anmeldenummer: 15790027.5
(22) Anmeldetag: 25.09.2015
(51) Int. Cl.: G01R 1/20, G01R 3/00, H01C 1/144, H01C 3/00, H01C 7/06, H01C 17/07, H01C 17/28

(54) **ELEKTRISCHES BAUELEMENT, HERSTELLUNGSVERFAHREN DAFÜR UND VERBUNDMATERIALBAND ZUM HERSTELLEN DES BAUELEMENTS**
ELECTRIC COMPONENT, METHOD FOR PRODUCING THE ELECTRIC COMPONENT, AND COMPOSITE MATERIAL STRIP FOR PRODUCING THE COMPONENT
COMPOSANT ÉLECTRIQUE, PROCÉDÉ DE FABRICATION ASSOCIÉ ET BANDE DE MATÉRIAU COMPOSITE POUR LA FABRICATION DU COMPOSANT

(30) Priorität: 24.10.2014 DE 102014015805
(43) Veröffentlichungstag der Anmeldung: 30.08.2017
(73) Patentinhaber: Isabellenhütte Heusler GmbH & Co. KG, 35683 Dillenburg (DE)
(72) Erfinder: HETZLER, Ullrich, 35688 Dillenburg-Oberscheld (DE)
(74) Vertreter: v. Bezold & Partner Patentanwälte - PartG mbB
(86) Internationale Anmeldenummer: PCT/EP2015/001912
(87) Internationale Veröffentlichungsnummer: WO 2016/062369

(56) Entgegenhaltungen:
- EP-A1- 0 605 800
- DE-A1-102006 031 839
- None

## Beschreibung

Die Erfindung betrifft ein Verbundmaterialband zur Herstellung eines elektrischen Widerstands, wie beispielsweise eines niederohmigen Strommesswiderstands ("Shunt"). Weiterhin betrifft die Erfindung ein entsprechendes Herstellungsverfahren sowie einen entsprechenden Widerstand.

Aus EP 0 605 800 A1 ist ein niederohmiger Strommesswiderstand bekannt, der aus zwei plattenförmigen Anschlussteilen aus einem Leitermaterial (z.B. Kupfer) und einem dazwischen eingesetzten, ebenfalls plattenförmigen Widerstandselement aus einem Widerstandsmaterial (z.B. Manganin®) besteht. Dieser bekannte Strommesswiderstand lässt sich kostengünstig aus einem Verbundmaterialband herstellen, das aus drei längsnahtverschweißten Materialbändern besteht. Die beiden äußeren Materialbänder bestehen hierbei aus dem Leitermaterial (z.B. Kupfer), während das mittlere Materialband aus dem Widerstandsmaterial (z.B. Manganin®) besteht. Die einzelnen Strommesswiderstände können dann aus dem Verbundmaterialband quer zur Bandlängsrichtung ausgestanzt werden. Hierbei ist zu erwähnen, dass die einzelnen Materialbänder des Verbundmaterialbands durch eine Elektronenstrahlverschweißung miteinander verbunden sind. Dies ist einfach möglich, weil sich das Widerstandsmaterial (z.B. Manganin®) einerseits und das Leitermaterial (z.B. Kupfer) andererseits gut verschweißen lassen.

Bei einigen Anwendungen besteht jedoch das technische Bedürfnis, den Strommesswiderstand einseitig mit einem Aluminiumanschlussteil auszuführen. Dies ist durch eine Elektronenstrahlverschweißung nicht möglich, da Aluminium einerseits und Kupfer bzw. Manganin® andererseits schlecht oder gar nicht miteinander verschweißt werden können. So bildet sich bei allen thermischen Schweißverfahren (z.B. WIG-Schweißen (WIG: Wolfram-Inert-Gas), Laserschweißen, Elektronenstrahlschweißen, u.a.) eine intermetallische Phase zwischen dem Aluminium und dem Kupfer aus, wobei diese intermetallische Phase äußerst spröde ist. Die Sprödigkeit der Schweißnaht führt wiederrum zu einer geringen Festigkeit, sodass sich dieses Verfahren nicht für industrielle Anwendungen eignet.

Kaltschweißverfahren (z.B. Reibschweißen) verhindern zwar die Entstehung dieser störenden intermetallischen Verbindung zwischen dem Aluminium-Bauteil und dem Kupfer-Bauteil. Allerdings sind diese Schweißverfahren nicht für die Herstellung eines mehrstreifigen Verbundmaterialbands geeignet. So funktioniert das bekannte Reibschweißen in der Regel nur an einem Einzelstück und ist deshalb relativ arbeitsintensiv und teuer.

Die Verbindung mit einem Aluminium-Bauteil ist beispielsweise in Hybrid- und Elektrofahrzeugen sinnvoll, die mit einem vergleichsweise hohen Dauerstrom gefahren werden, sodass die Stromschienen einen deutlich größeren Querschnitt als bei herkömmlichen Fahrzeugen mit einem Verbrennungsmotor haben müssen. Ähnliches trifft aber auch für alle anderen modernen Kraftfahrzeuge zu, da immer mehr Funktionen über elektrische Aktoren (Ventile, Motoren) realisiert werden, wodurch der mittlere Dauerstrom bei größeren Fahrzeugen bereits in die Nähe von 200 Ampere kommt. Aus Gewichts- und Kostengründen werden deshalb Stromschienen mehr und mehr aus Aluminium gefertigt. Sowohl an der Masseseite als auch an der Spannungsseite (Batterie bzw. Generator) ist aber ein Übergang von der Aluminium-Stromschiene in die üblicherweise aus Kupfer bestehenden Bauelemente erforderlich.

Aus DE 10 2012 006 641 A1 ist ein Kabelanschlusselement bekannt, bei dem eine Einlage aus Aluminium auf ein Flachteil aus Kupfer aufplattiert wird. Das Kupferteil und das Aluminiumteil sind hierbei also planparallel zueinander angeordnet, was eine Herstellung aus einem Verbundmaterialband ausschließt.

Ähnliches gilt für US 3 895 851. So offenbart diese Druckschrift ein Kabelanschlusselement, bei dem eine Aluminiumbeschichtung auf ein Kupferteil aufgebracht wird. Auch dieser Aufbau schließt eine Herstellung aus einem Verbundmaterialband aus.

Auch bei US 3 157 735 und DE 10 2004 009 651 A1 sind das Aluminiumteil und das Kupferteil planparallel zueinander angeordnet, was eine Herstellung aus einem Verbundmaterialband ausschließt.

Ferner ist zum Stand der Technik hinzuweisen auf DE 42 43 349 A1 und DE 10 2012 013 036 A1.

Schließlich ist aus DE 10 2006 031 839 A1 ein Herstellungsverfahren für ein Kontaktelement bekannt. Dabei werden zwei Materialbänder aus Kupfer bzw. Aluminium entlang ihrer Längskanten zusammengeschweißt. Ein Widerstand und ein entsprechendes Herstellungsverfahren sind aus dieser Druckschrift jedoch nicht bekannt.

Der Erfindung liegt deshalb die Aufgabe zugrunde, einen solchen Übergang von einem Aluminium-Bauteil zu einem Kupfer-Bauteil zu ermöglichen.

Diese Aufgabe wird gelöst durch ein Verbundmaterialband, ein Herstellungsverfahren und einen entsprechenden Widerstand gemäß den Nebenansprüchen.

Die Erfindung beruht auf der technisch-physikalischen Erkenntnis, dass eine solche Verbindung zwischen einem Aluminium-Bauteil einerseits und einem kupferhaltigen Bauteil andererseits durch ein besonderes Fügeverfahren ermöglicht wird, wie beispielsweise durch Walzplattieren (z.B. Laser-Induktions-Walzplattieren oder Laser-Walzplattieren) oder auch durch Ultraschall-Schweißen. Eine solche Verbindung zwischen einem Aluminium-Bauteil einerseits und einem kupferhaltigen Bauteil andererseits kann auch als "Transition Joint" bezeichnet werden. Die Erfindung ist jedoch hinsichtlich des verwendeten Fügeverfahrens nicht auf diese Beispiele beschränkt, sondern auch mit anderen Fügeverfahren realisierbar, die es ermöglichen, ein aluminiumhaltiges Bauteil mit einem kupferhaltigen Bauteil zu verbinden.

Das Laser-Induktions-Walzplattieren ist an sich aus dem Stand der Technik bekannt und muss deshalb nicht näher beschrieben werden. Lediglich beispielhaft wird auf DE 10 2008 036 435 A1 verwiesen.

Auch das Ultraschall-Schweißen ist an sich aus dem Stand der Technik bekannt und muss deshalb nicht näher beschrieben werden.

Die Erfindung umfasst zunächst ein Verbundmaterialband zur Herstellung eines elektrischen Bauelements, wie beispielsweise eines Widerstands, insbesondere eines niederohmigen Strommesswiderstands, wie er beispielsweise aus EP 0 605 800 A1 bekannt ist. Das erfindungsgemäße Verbundmaterialband besteht zunächst in Übereinstimmung mit dem aus EP 0 605 800 A1 bekannten Verbundmaterialband aus mehreren Materialbändern, die jeweils paarweise entlang einer Längsnaht miteinander verbunden sind. Das erste Materialband in dem Verbundmaterialband besteht hierbei aus einem kupferhaltigen Leitermaterial, und dient zur späteren Ausbildung eines ersten Anschlussteils des elektrischen Bauelements. Das zweite Materialband des Verbundmaterialbands dient dagegen zur späteren Ausbildung eines zweiten Anschlussteils des elektrischen Bauelements, wobei das erste Materialband und das zweite Materialband entlang einer Längsnaht elektrisch und mechanisch miteinander verbunden sind. Das erfindungsgemäße Verbundmaterialband unterscheidet sich nun von dem bekannten Verbundmaterialband gemäß EP 0 605 800 A1 dadurch, dass das zweite Materialband aus einem aluminiumhaltigen Leitermaterial besteht. Das erfindungsgemäße Verbundmaterialband besteht also aus mehreren Materialbändern, von denen das erste Materialband aus einem kupferhaltigen Material besteht, während das zweite Materialband aus einem aluminiumhaltigen Material besteht. Diese Zusammenfügung eines aluminiumhaltigen Materials mit einem kupferhaltigen Material wird im Rahmen der Erfindung durch die Verwendung eines geeigneten Fügeverfahrens ermöglicht. Beispielsweise eignen sich hierfür das bekannte Walzplattieren (z.B. Laser-Induktions-Walzplattieren oder Laser-Walzplattieren) und das ebenfalls bekannte Ultraschallschweißen.

Der im Rahmen der Erfindung verwendete Begriff eines Anschlussteils hat die Bedeutung, dass das Anschlussteil mechanisch und elektrisch mit dem Widerstandselement verbunden ist. Vorzugsweise dient das Anschlussteil auch als elektrischer Anschlusskontakt, beispielsweise zur Einleitung bzw.

Abführung des elektrischen Stroms oder zur Spannungsmessung entsprechend der Vierleitertechnik. Der Begriff eines Anschlussteils ist jedoch im Rahmen der Erfindung so allgemein zu verstehen, dass er auch Anschlussteile umfasst, die unmittelbar weder zur Spannungsmessung noch zur Einleitung bzw. Abführung des elektrischen Stroms dienen, sondern lediglich mit den eigentlichen Anschlusskontakten verbunden sind.

Gemäß der Erfindung weist das Verbundmaterial zusätzlich ein drittes Materialband auf, das aus einem Widerstandsmaterial (z.B. Kuper-Mangan-Nickel-Legierung) besteht, wobei das dritte Materialband zur späteren Ausbildung eines Widerstandselements des fertigen Bauelements dient. Dieses dritte Materialband ist dann entlang einer Längsnaht elektrisch und mechanisch mit dem ersten Materialband verbunden, das aus dem kupferhaltigen Leitermaterial besteht.

Gemäß der Erfindung weist das erfindungsgemäße Verbundmaterialband sogar ein viertes Materialband auf, das aus dem kupferhaltigen Leitermaterial besteht und zur späteren Ausbildung eines dritten Anschlussteils des Bauelements dient. Dieses vierte Materialband ist dann entlang seiner Längskante elektrisch und mechanisch mit dem dritten Materialband aus dem Widerstandmaterial verbunden.

Das aus dem kupferhaltigen Material bestehende erste Materialband kann hierbei aus einem einzigen Materialband bestehen. Es besteht jedoch alternativ auch die Möglichkeit, dass das aus dem kupferhaltigen Material bestehende erste Materialband seinerseits aus zwei Materialbändern besteht, die entlang einer Längsnaht zusammengefügt sind, vorzugsweise durch eine Elektronenstrahlverschweißung.

Das aus dem aluminiumhaltigen Material bestehende zweite Materialband kann ebenfalls aus einem einzigen Materialband bestehen. Es besteht jedoch alternativ auch die Möglichkeit, dass das aus dem aluminiumhaltigen Material bestehende zweite Materialband aus zwei Materialbändern zusammengefügt ist, vorzugsweise durch eine Elektronenstrahlverschweißung.

Bei einer Zusammenfügung des ersten oder zweiten Materialbands aus jeweils zwei oder mehreren Materialbändern besteht die Möglichkeit, dass die zusammenzufügenden Materialbänder gleich dick sind. Es besteht jedoch alternativ auch die Möglichkeit, dass die zusammenzufügenden Materialbänder unterschiedlich dick sind.

Es wurde bereits vorstehend kurz erwähnt, dass die Zusammenfügung des ersten Materialbands aus dem kupferhaltigen Material mit dem zweiten Materialband aus dem aluminiumhaltigen Material durch ein geeignetes Fügeverfahren erfolgt, das es ermöglicht, Aluminium und Kupfer zusammenzufügen. Beispielsweise eignet sich das bekannte Walzplattieren, insbesondere das Laser-Induktions-Walzplattieren oder das Laser-Walzplattieren. Ein anderes geeignetes Fügeverfahren zum Zusammenfügen von Aluminium und Kupfer ist das ebenfalls bekannte Ultraschall-Schweißen.

Das Zusammenfügen der Materialbänder aus dem kupferhaltigen Material (z.B. Kupfer, Kupfer-Mangan-Nickel-Legierung) sowie das Zusammenfügen von zwei aluminiumhaltigen Bändern kann dagegen durch eine herkömmliche Schweißverbindung erfolgen, wobei sich das bekannte Elektronenstrahlschweißen als besonders vorteilhaft erwiesen hat.

In dem bevorzugten Ausführungsbeispiel der Erfindung werden also nur die Längsnähte zwischen aluminiumhaltigen Bauteilen einerseits und kupferhaltigen Bauteilen andererseits durch ein besonderes Schweißverfahren (z.B. Laser-Induktions-Walzplattieren) hergestellt, während alle anderen Längsnähte vorzugsweise durch Elektronenstrahlschweißen hergestellt werden.

Bei dem kupferhaltigen Material handelt es sich um ein Leitermaterial, wie beispielsweise Kupfer oder eine Kupferlegierung.

Bei dem aluminiumhaltigen Material handelt es sich ebenfalls um ein Leitermaterial, wie beispielsweise Aluminium oder eine Aluminiumlegierung.

Das vorstehend bereits erwähnte Widerstandsmaterial hat dagegen vorzugsweise einen größeren spezifischen elektrischen Widerstand als das Leitermaterial. Der spezifische elektrische Widerstand des Widerstandsmaterials kann beispielsweise im Bereich von 1·10⁻⁸ Ωm bis 50·10⁻⁷ Ωm liegen, wobei innerhalb dieses Wertebereichs verschiedene Werte möglich sind.

Ein Beispiel für das Widerstandsmaterial ist eine Kupfer-Mangan-Legierung, insbesondere eine Kupfer-Mangan-Nickel-Legierung (z.B. Manganin®). Ein anderes Beispiel für ein Widerstandsmaterial ist dagegen eine Nickel-Chrom-Legierung.

Ferner ist zu erwähnen, dass das aus dem Widerstandsmaterial bestehende Materialband dünner sein kann als die anderen Materialbänder, die vorzugsweise gleich dick sind.

Neben dem vorstehend beschriebenen erfindungsgemäßen Verbundmaterialband umfasst die Erfindung auch ein entsprechendes Herstellungsverfahren zur Herstellung eines elektrischen Widerstands (z.B. niederohmiger Strommesswiderstand).

Im Rahmen des erfindungsgemäßen Herstellungsverfahrens werden zunächst zwei schmale Materialbänder entlang ihrer Längsnaht elektrisch und mechanisch miteinander verbunden, wobei das erste Materialband aus einem kupferhaltigen Leitermaterial besteht, während das zweite Materialband aus einem aluminiumhaltigen Leitermaterial besteht. Die Verbindung wird vorzugsweise mit dem erwähnten Walzplattieren, insbesondere Laser-Induktions-Walzplattieren oder Laser-Walzplattieren, hergestellt. An den jeweils freien Kupfer- bzw. Aluminium-Seiten können dann weitere aluminium- bzw. kupferhaltige Bänder (inklusive Widerstandsmaterialien) mit dem bekannten und erprobten Elektronenstrahl-Schweißverfahren angeschweißt werden.

Bei dem erfindungsgemäßen Herstellungsverfahren besteht ein drittes Materialband aus einem Widerstandsmaterial, wie beispielsweise einer Kupfer-Mangan-Nickel-Legierung. Dieses dritte Materialband dient zur späteren Ausbildung eines Widerstandselements des Bauelements. Dieses dritte Materialband wird im Rahmen des erfindungsgemäßen Herstellungsverfahrens mit dem ersten Materialband aus dem kupferhaltigen Leitermaterial elektrisch und mechanisch zusammengefügt, beispielsweise durch eine Elektronenstrahlverschweißung.

Darüber hinaus wird noch ein viertes Materialband hinzugefügt, das aus dem kupferhaltigen Material besteht, um später ein Anschlussteil des herzustellenden Bauelements auszubilden. Dieses vierte Materialband wird dann mit dem dritten Materialband aus dem Widerstandsmaterial zusammengefügt. Auf der Aluminium-Seite des ersten Verbundmaterials wird ebenfalls mit Elektronenstrahlschweißen ein aluminiumhaltiges Band als fünftes Band vorzugweise ein Leitermaterial angeschweißt, um später ein zweites Anschlussteil des herzustellenden Bauelements auszubilden. Im Ergebnis kann das Verbundmaterialband dann eine Abfolge von Materialbändern mit der Abfolge Aluminium-Kupfer-Manganin®-Kupfer haben.

In einer Variante der Erfindung wird das Verbundmaterialband zusammengefügt aus einem Tri-Band mit drei zusammengefügten Materialbändern und einem Bi-Band mit zwei zusammengefügten Materialbändern. Das Tri-Band hat hierbei zwei äußere Materialbänder aus dem kupferhaltigen Leitermaterial und ein mittleres Materialband aus dem Widerstandsmaterial. Das Bi-Band hat dagegen ein Materialband aus dem kupferhaltigen Leitermaterial und ein Materialband aus dem aluminiumhaltigen Leitermaterial. Beim Zusammenfügen des Tri-Bands mit dem Bi-Band erfolgt dann eine Zusammenfügung des kupferhaltigen Materialbands des Tri-Bands mit dem kupferhaltigen Materialband des Bi-Bands. Dies ermöglicht es beim Zusammenfügen des Tri-Bands mit dem Bi-Band, dass ein herkömmliches Fügeverfahren zum Einsatz kommt, wie beispielsweise Elektronenstrahlschweißen.

Abschließend wird auf der Aluminium-Seite des Verbundmaterials ebenfalls mit Elektronenstrahlschweißen ein aluminiumhaltiges Band als fünftes Band (vorzugweise aus einem Leitermaterial) angeschweißt, um später ein zweites Anschlussteil des herzustellenden Bauelements auszubilden.

Es ist jedoch alternativ auch möglich, dass das erfindungsgemäße Verbundmaterialband aus zwei Bi-Bändern zusammengefügt wird. Das erste Bi-Band weist dann ein Materialband aus dem kupferhaltigen Leitermaterial und ein Materialband aus dem aluminiumhaltigen Leitermaterial auf. Das zweite Bi-Band enthält dagegen ein Materialband aus dem Widerstandsmaterial und ein Materialband aus dem kupferhaltigen Leitermaterial. Die beiden Bi-Bänder werden dann so zusammengefügt, dass jeweils die kupferhaltigen Materialbänder zusammengefügt werden. Auch dies ermöglicht wieder die Verwendung eines herkömmlichen Fügeverfahrens, wie beispielsweise Elektronenstrahlschweißen.

Abschließend wird auf der Aluminium-Seite des ebenfalls mit Elektronenstrahlschweißen ein aluminiumhaltiges Band als fünftes Band (vorzugweise aus einem Leitermaterial) angeschweißt, um später ein zweites Anschlussteil des herzustellenden Widerstands auszubilden.

Im Rahmen des erfindungsgemäßen Herstellungsverfahrens erfolgt dann vorzugsweise auch noch eine Vereinzelung der einzelnen elektrischen Widerstände von dem Verbundmaterialband quer zu dem Verbundmaterialband. Hierzu werden die einzelnen elektrischen Widerstände quer zur Bandlängsrichtung abgetrennt, beispielsweise durch Stanzen.

Anschließend können die vereinzelten Widerstände dann noch gebogen werden, beispielsweise quer zur Bandlängsrichtung.

Ein weiterer Verfahrensschritt kann darin bestehen, dass der elektrische Widerstandswert des von dem Verbundmaterialband abgetrennten Widerstands justiert wird. Hierzu können beispielsweise mittels eines Lasers Einkerbungen in das Widerstandselement eingeschnitten werden, um den gewünschten elektrischen Widerstandswert einzustellen.

Schließlich umfasst die Erfindung auch einen elektrischen Widerstand, wie beispielsweise einen niederohmigen Strommesswiderstand. Der Widerstand umfasst zwei Anschlussteile, die elektrisch und mechanisch zusammengefügt sind. Das erste Anschlussteil besteht hierbei aus einem kupferhaltigen Leitermaterial. Das zweite Anschlussteil besteht dagegen aus einem aluminiumhaltigen Leitermaterial. Die beiden Anschlussteile können beispielsweise durch Laser-Induktions-Walzplattieren miteinander verbunden sein.

Darüber hinaus umfasst der erfindungsgemäße Widerstand auch ein Widerstandselement aus einem Widerstandsmaterial (z.B. Manganin®), wobei das Widerstandselement elektrisch und mechanisch mit dem ersten Anschlussteil aus dem kupferhaltigen Leitermaterial verbunden ist, beispielsweise durch eine herkömmliche Elektronenstrahlverschweißung. Hierbei weist der Widerstand auch ein drittes Anschlussteil aus dem kupferhaltigen Leitermaterial auf, wobei das dritte Anschlussteil aus dem kupferhaltigen Leitermaterial mit dem Widerstandselement verbunden ist, beispielsweise durch eine Elektronenstrahlverschweißung. Das Widerstandselement befindet sich hierbei also im Stromflusspfad zwischen dem ersten Anschlussteil aus dem kupferhaltigen Leitermaterial und dem dritten Anschlussteil aus dem kupferhaltigen Leitermaterial.

Ferner ist zu erwähnen, dass die Anschlussteile und/oder das Widerstandselement vorzugsweise plattenförmig sind. Dies bedeutet, dass die Anschlussteile bzw. das Widerstandselement relativ dünn sind und parallele Ober- und Unterseiten haben.

Die Anschlussteile und das Widerstandselement können hierbei wahlweise eben oder gebogen sein, was an sich aus dem Stand der Technik bekannt ist.

Bei dem kupferhaltigen Leitermaterial handelt es sich vorzugsweise um Kupfer oder eine Kupfer-Legierung.

Bei dem aluminiumhaltigen Material handelt es sich dagegen vorzugsweise um reines Aluminium oder eine Aluminium-Legierung.

Beispiele für das Widerstandsmaterial sind eine Kupfer-Mangan-Legierung, insbesondere eine Kupfer-Mangan-Nickel-Legierung (z.B. Manganin®) und eine Nickel-Chrom-Legierung.

Weiterhin ist zu erwähnen, dass das Widerstandsmaterial des Widerstandselements vorzugsweise einen größeren spezifischen elektrischen Widerstand aufweist als das Leitermaterial.

Allerdings ist das Widerstandsmaterial des Widerstandselements vorzugsweise niederohmig. Dies bedeutet vorzugsweise, dass das Widerstandsmaterial einen spezifischen elektrischen Widerstand aufweist, der beispielsweise im Bereich von 1·10⁻⁸ Ωm bis 50·10⁻⁷ Ωm liegen kann.

Der Widerstandswert des kompletten Widerstands liegt dagegen vorzugsweise im Bereich von 0,1 µΩ bis 1 mΩ.

Ferner ist zu erwähnen, dass der erfindungsgemäße Widerstand eine Dauerstromfestigkeit von mindestens 100 A, 1 kA, 2 kA, 5kA oder sogar 10 kA aufweisen kann.

Die Dicke des erfindungsgemäßen Widerstands liegt dagegen vorzugsweise im Bereich von 0,2 mm bis 20 mm, wobei bestimmte Werte innerhalb dieses Wertebereichs möglich sind.

Darüber hinaus ist noch zu erwähnen, dass der erfindungsgemäße Widerstand vorzugsweise relativ temperaturkonstant ist. Der Widerstandswert des erfindungsgemäßen Widerstands weist deshalb vorzugsweise einen Temperaturkoeffizienten von weniger als 500 ppm/K, 200 ppm/K oder 50 ppm/K auf.

Darüber hinaus ist die Induktivität des erfindungsgemäßen Widerstands vorzugsweise geringer als 10 nH, 3 nH oder sogar 1 nH.

Die Länge in Stromflussrichtung beträgt bei dem erfindungsgemäßen Widerstand vorzugsweise 10 mm bis 150 mm, während die Breite vorzugsweise im Bereich von 5 mm bis 20 mm liegt.

Ferner umfasst die Erfindung auch eine Stromschienenanordnung mit einer ersten Stromschiene aus einem aluminiumhaltigen Leitermaterial und einem erfindungsgemäßen Widerstand. Das aus dem aluminiumhaltigen Leitermaterial bestehende zweite Anschlussteil des Widerstands wird hierbei elektrisch und mechanisch mit der ersten Stromschiene verbunden, die ebenfalls aus einem aluminiumhaltigen Leitermaterial besteht. Beispielsweise kann diese Verbindung durch eine Schraubverbindung, eine Nietverbindung oder eine Verschweißung erfolgen. Auf diese Weise kann eine Verbindung hergestellt werden zwischen der sogenannten Kupfer-Welt und der sogenannten Aluminium-Welt.

Darüber hinaus kann auch eine zweite Stromschiene aus einem kupferhaltigen Leitermaterial vorgesehen sein. Der erfindungsgemäße Widerstand kontaktiert dann einerseits die Aluminium-Stromschiene und andererseits die Kupfer-Stromschiene.

Schließlich kann die erfindungsgemäße Stromschienenanordnung auch einen Kondensator aufweisen, wie beispielsweise ein Aluminium-Elektrolyt-Kondensator (Elko) mit Kontaktzonen aus einem aluminiumhaltigen Leitermaterial.

Andere vorteilhafte Weiterbildungen der Erfindung sind in den Unteransprüchen gekennzeichnet oder werden nachfolgend zusammen mit der Beschreibung der bevorzugten Ausführungsbeispiele der Erfindung anhand der Figuren näher erläutert. Es zeigen:
- Figuren 1A-1F: verschiedene aufeinanderfolgende Herstellungsstadien bei der Herstellung eines erfindungsgemäßen Verbundmaterialbands,
- Figuren 2A-2F: die Verfahrensstadien aus den Figuren 1A-1F in einer Querschnittsansicht,
- Figur 3: das Herstellungsverfahren gemäß den Figuren 1A-1F und 2A-2F in Form eines Flussdiagramms,
- Figuren 4A-4F: verschiedene Verfahrensstadien bei der Herstellung eines alternativen Ausführungsbeispiels eines Verbundmaterialbands gemäß der Erfindung,
- Figuren 5A-5F: die Verfahrensstadien aus den Figuren 4A-4F jeweils in einer Querschnittsansicht,
- Figur 6: das Herstellungsverfahren gemäß den Figuren 4A-4F und 5A-5F in Form eines Flussdiagramms,
- Figur 7: eine schematische Querschnittsansicht durch ein nicht erfindungsgemäßes Bauelement zur elektrischen Kontaktierung,
- Figur 8: eine Abwandlung von Figur 7,
- Figur 9: eine schematische Darstellung zur Verdeutlichung der Herstellung eines Strommesswiderstands aus einem Verbundmaterialband mit drei Bändern,
- Figur 10: eine schematische Darstellung zur Herstellung eines Strommesswiderstandes aus einem verbundenen Materialband mit vier Materialbändern,
- Figur 11: eine schematische Darstellung des Anschlusses einer Aluminium-Stromschiene an eine Batterieklemme mit einem Strommesswiderstand,
- Figur 12: eine schematische Darstellung der Verbindung einer Aluminium-Stromschiene mit einer Kupfer-Stromschiene,
- Figur 13: eine Abwandlung von Figur 5F.

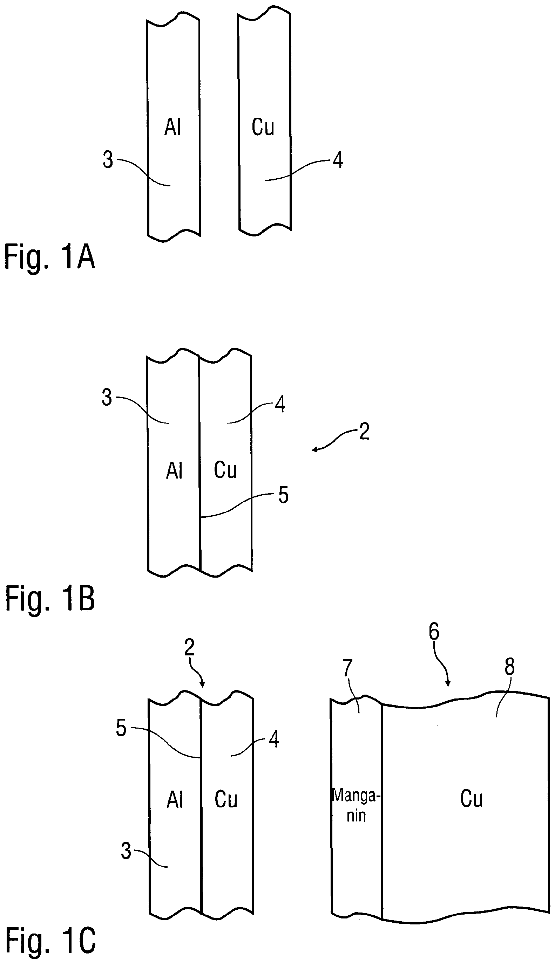

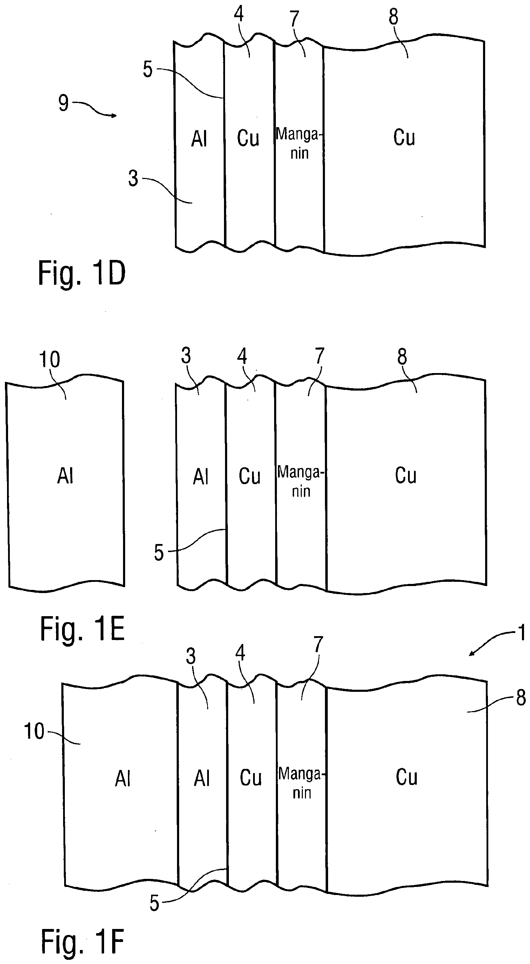

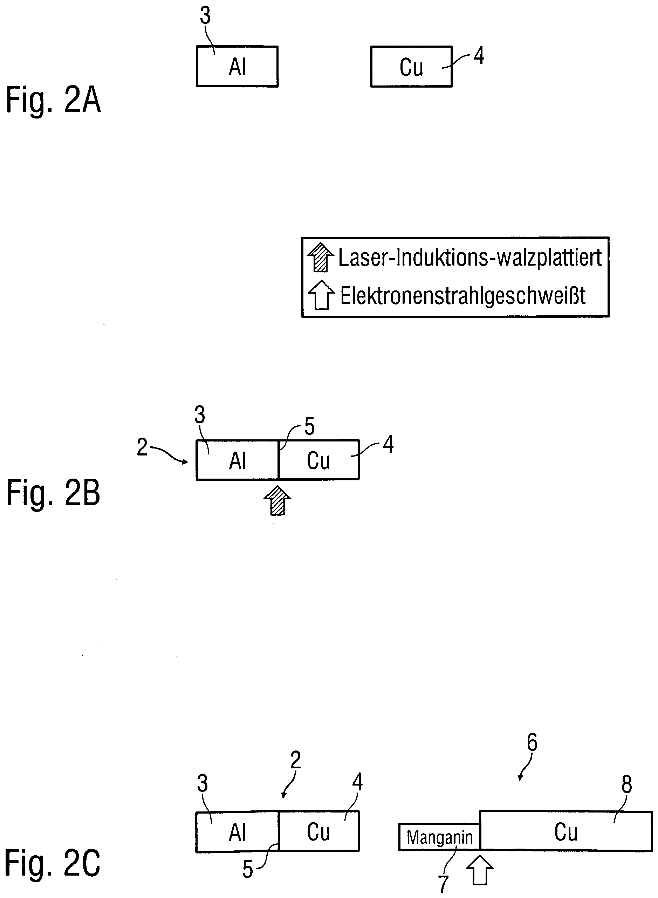

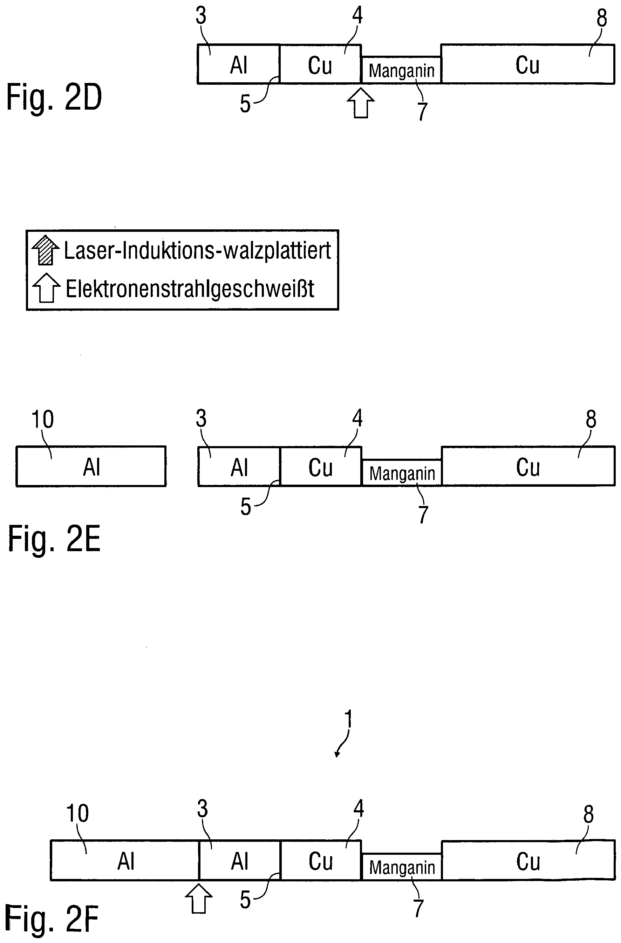

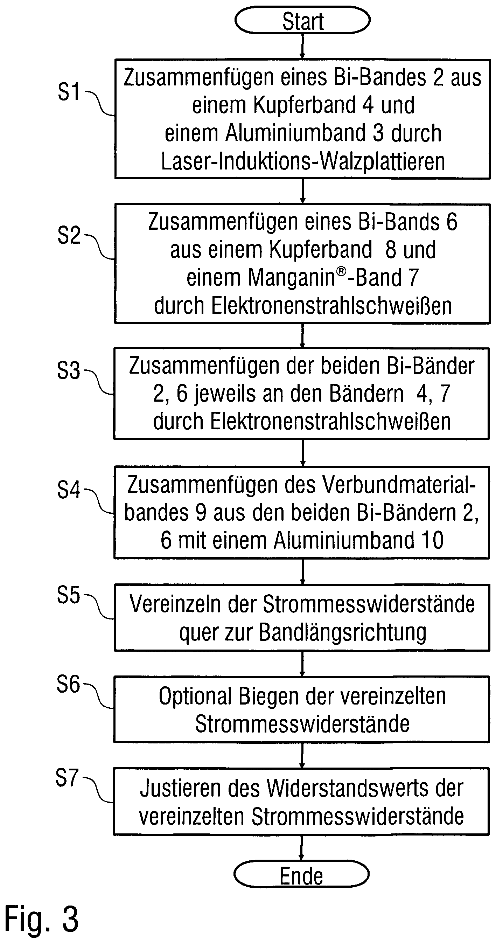

Im Folgenden wird nun zunächst ein erstes Ausführungsbeispiel beschrieben, das in den Figuren 1A-1F, 2A-2F und 3 dargestellt ist. Die Figuren 1A-1F zeigen jeweils verschiedene Verfahrensstadien des erfindungsgemäßen Herstellungsverfahrens zur Herstellung eines fertigen Verbundmaterialbands 1, wie es in Figur 1F dargestellt ist. Die Figuren 2A-2F zeigen eine Aufsicht auf die einzelnen Verfahrensstadien gemäß den Figuren 1A-1F. Die Figur 3 zeigt dagegen das Herstellungsverfahrens in Form eines Flussdiagramms.

In einem ersten Verfahrensschritt S1 wird zunächst ein Bi-Band 2 aus einem Aluminium-Band 3 und einem Kupfer-Band 4 zusammengefügt und zwar beispielsweise durch Laser-Induktions-Walzplattieren entlang einer Längsnaht 5.

In einem zweiten Schritt S2 wird dann ein weiteres Bi-Band 6 aus einem Manganin®-Band 7 und einem Kupfer-Band 8 zusammengefügt und zwar beispielsweise durch Elektronenstrahlschweißen.

In einem dritten Schritt S3 werden dann die beiden Bi-Bänder 2, 6 durch Elektronenstrahlschweißen zusammengefügt. Hierbei wird das Kupferband 4 mit dem Manganin®-Band 7 verschweißt, was einfach durch Elektronenstrahlschweißen erfolgen kann.

In einem weiteren Schritt S4 wird dann das resultierende Verbundmaterialband 9 mit einem weiteren Aluminium-Band 10 zusammengefügt und zwar durch Elektronenstrahlschweißen.

In einem nächsten Schritt S5 wird dann das in den Figuren 1F und 2F dargestellte Verbundmaterialband quer zur Bandlängsrichtung in einzelne Strommesswiderstände aufgeteilt, beispielsweise durch Stanzen quer zur Bandlängsrichtung.

In einem optionalen Schritt S6 können die vereinzelten Strommesswiderstände dann noch gebogen werden.

Schließlich erfolgt in einem Schritt S7 dann noch ein Justieren des Widerstandswerts der vereinzelten Strommesswiderstände, was in herkömmlicher Weise erfolgen kann.

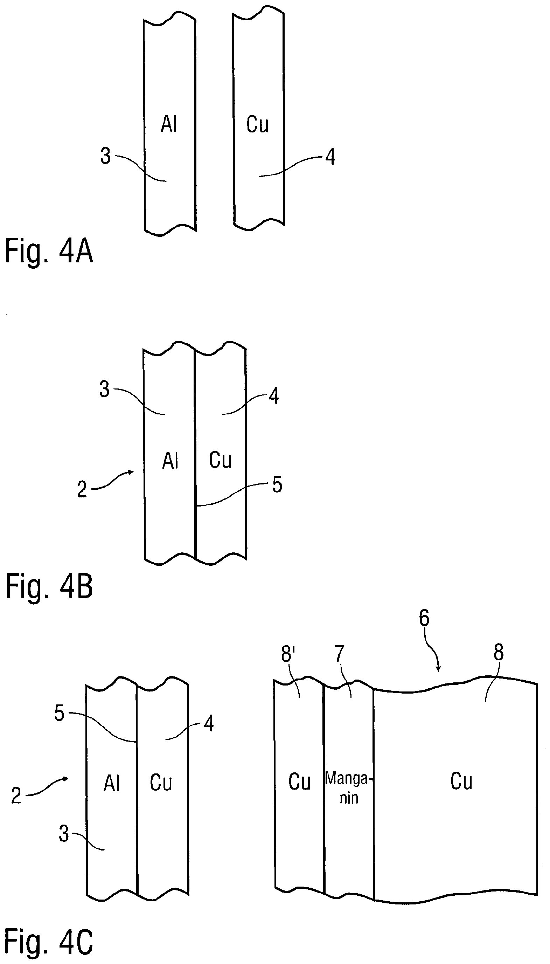

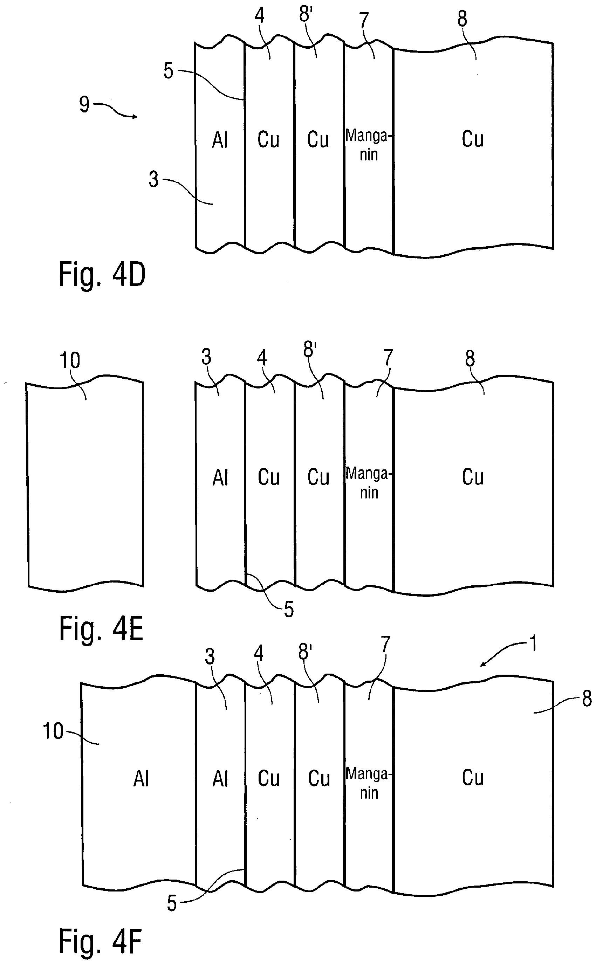

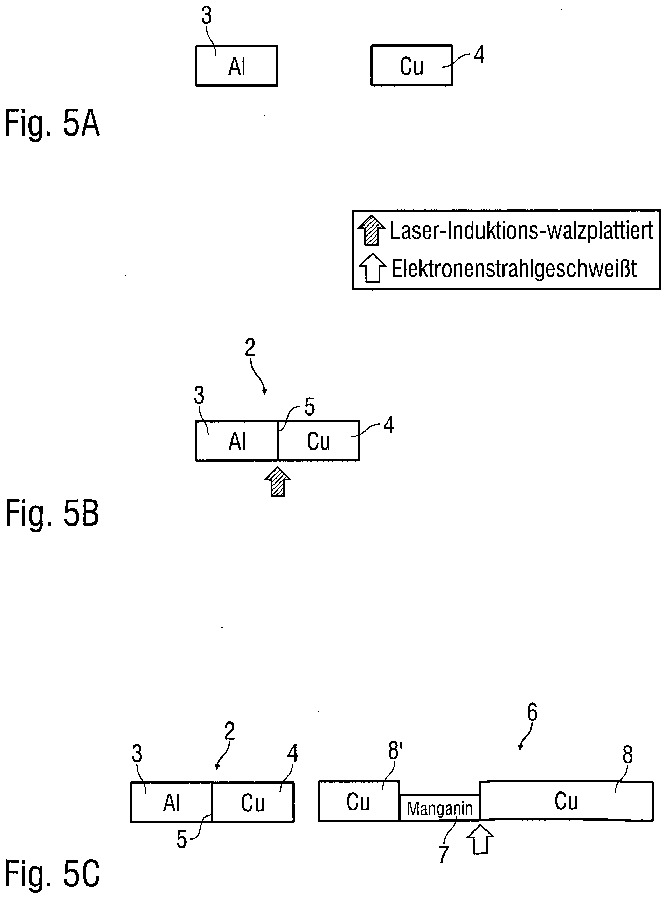

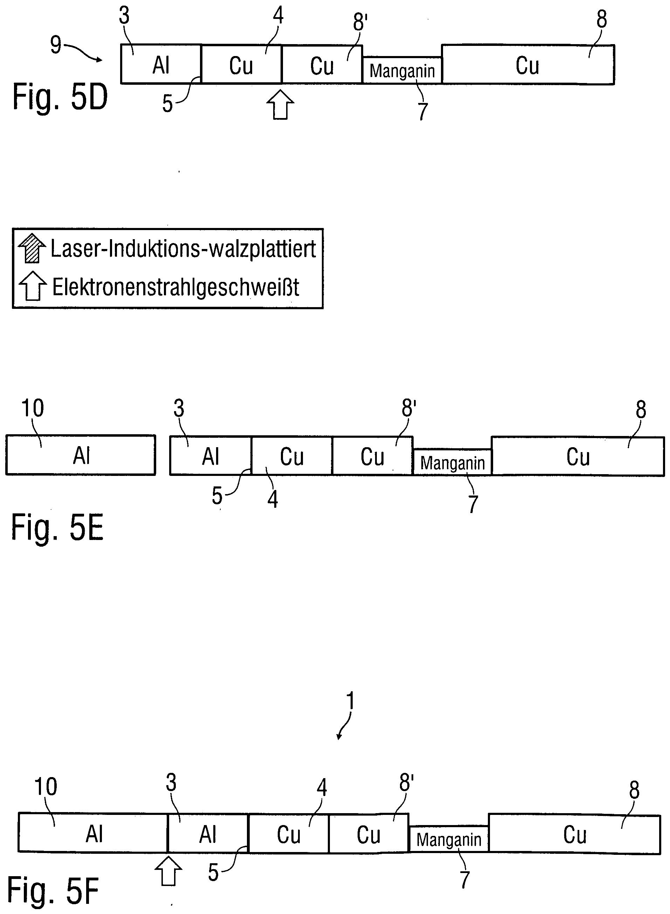

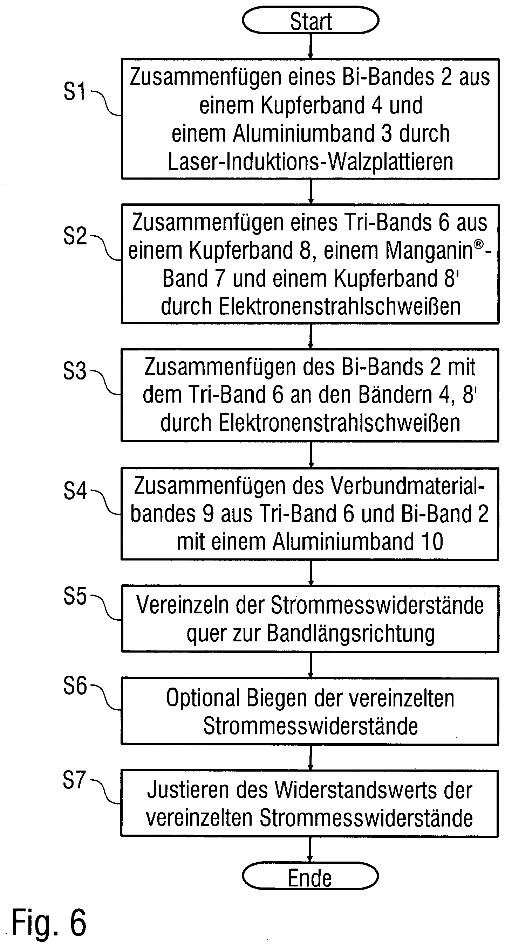

Die Figuren 4A-4F, 5A-5F und 6 zeigen eine Abwandlung des vorstehend beschriebenen Ausführungsbeispiels gemäß den Figuren 1A-1F, 2A-2F und 3, sodass zur Vermeidung von Wiederholungen auf die vorstehende Beschreibung verwiesen wird, wobei für entsprechende Einzelheiten dieselben Bezugszeichen verwenden werden.

Eine Besonderheit dieses Ausführungsbeispiels besteht darin, dass an Stelle des Bi-Bands 6 ein Tri-Band 6' vorgesehen ist. Das Tri-Band 6' weist zusätzlich zu dem Kupfer-Band 8 und dem Manganin®-Band 7 ein weiteres Kupfer-Band 8' auf.

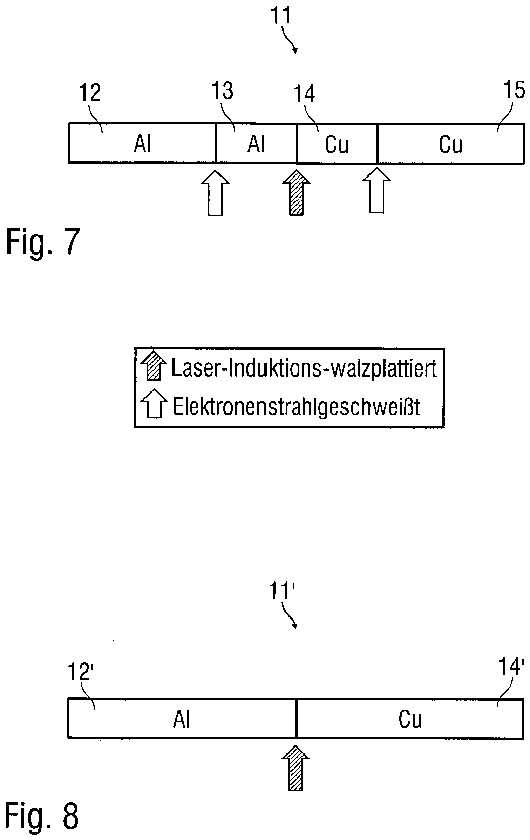

Figur 7 zeigt eine vereinfachte Querschnittsdarstellung eines nicht erfindungsgemäßen elektrischen Bauelements 11 zur elektrischen Kontaktierung, beispielsweise von Stromschienen.

Das Bauelement 11 besteht aus zwei plattenförmigen AluminiumTeilen 12, 13 und zwei ebenfalls plattenförmigen Kupfer-Bauteilen 14, 15.

Die beiden Aluminium-Bauteile 12, 13 und die beiden Kupfer-Bauteile 14, 15 sind jeweils durch Elektronenstrahlschweißen elektrisch und mechanisch miteinander verbunden.

Die Verbindung zwischen dem Aluminium-Bauteil 13 und dem Kupfer-Bauteil 14 erfolgt dagegen durch Laser-Induktions-Walzplattieren.

Figur 8 zeigte eine Abwandlung von Figur 7. Hierbei ist ein Bauteil 11' vorgesehen, das aus einem einzigen Aluminium-Bauteil 12' und einem einzigen Kupfer-Bauteil 14' durch Laser-Induktions-Walzplattieren zusammengefügt ist.

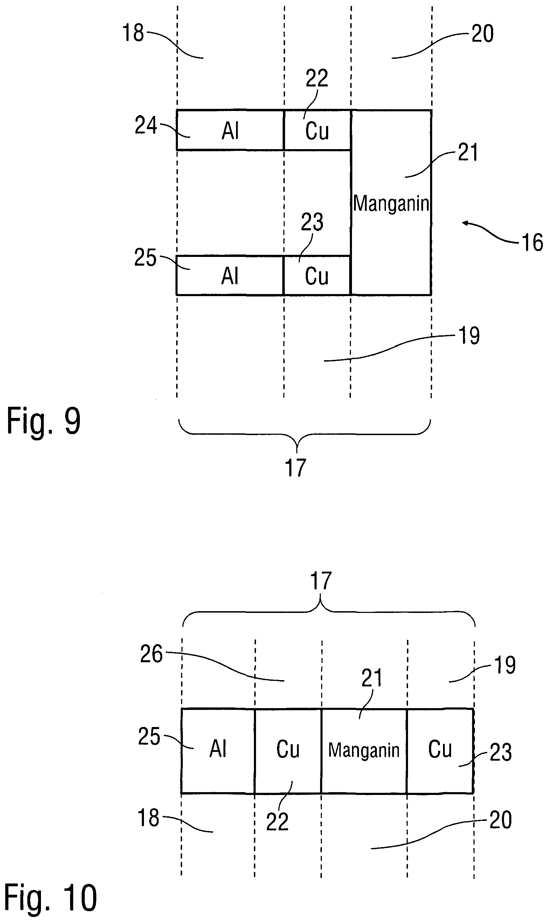

Figur 9 zeigt eine schematische Darstellung zur Herstellung eines nicht erfindungsgemäßen Strommesswiderstands 16 aus einem Verbundmaterialband 17, das aus einem Aluminium-Band 18 einem Kupfer-Band 19 und einem Manganin®-Band 20 besteht.

Der Strommesswiderstand 16 besteht hierbei aus einem Widerstandselement 21 aus Manganin®, zwei Anschlussteilen 22, 23 aus Kupfer und zwei Anschlussteilen 24, 25 aus Aluminium.

Die Anschlussteile 22, 24, 23, 25 sind hierbei also auf derselben Seite des Widerstandselements 21 angeordnet, was an sich aus der bereits eingangs zitierten Patentanmeldung EP 0 605 800 A1 bekannt ist.

Figur 10 zeigt dagegen eine Abwandlung des Ausführungsbeispiels gemäß Figur 9, sodass zur Vermeidung von Wiederholungen zunächst auf die vorstehende Beschreibung zu Figur 9 verwiesen wird, wobei für entsprechende Einzelheiten dieselben Bezugszeichen verwendet werden.

Eine Besonderheit dieses Ausführungsbeispiels besteht zunächst darin, dass das Verbundmaterialband 17 zusätzlich ein weiteres Kupfer-Band 26 aufweist. Die beiden Anschlussteile 23, 22 sind hierbei also auf gegenüberliegenden Seiten des Widerstandselements 21 angeordnet, was ebenfalls bereits an sich aus EP 0 605 800 A1 bekannt ist.

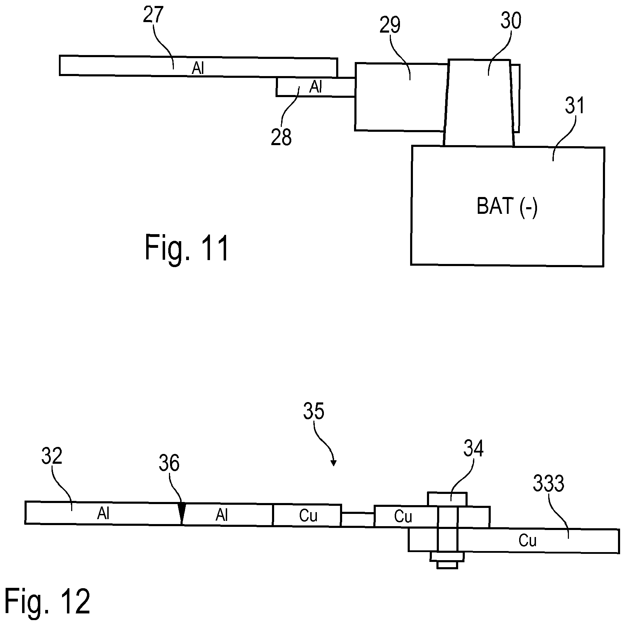

Figur 11 zeigt eine schematische Darstellung zur Verdeutlichung des elektrischen Anschlusses einer Aluminium-Stromschiene 27 über einen Aluminium-Anschluss 28 an eine Batterieklemme 29 eines negativen Pols 30 einer Batterie 31.

Auch hierbei kann eine Verbindung hergestellt werden zwischen der "Aluminium-Welt" der Aluminium-Stromschiene 27 einerseits und der "Kupfer-Welt" der Batterieklemme 29 andererseits.

Figur 12 zeigt eine schematische Darstellung zur Verbindung einer Aluminium-Stromschiene 32 mit einer Kupfer-Stromschiene 33 über eine Verschraubung 34, einen Strommesswiderstand 35 und eine Verschweißung 36.

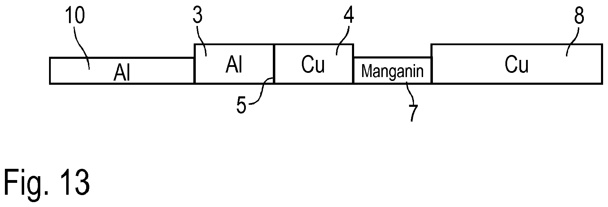

Figur 13 zeigt schließlich eine Abwandlung von Figur 2F, sodass zur Vermeidung von Wiederholungen auf die vorstehende Beschreibung verwiesen wird.

Eine Besonderheit dieser Abwandlung besteht darin, dass das Aluminium-Band 3 dünner als die anderen Bänder.

### Bezugszeichenliste

- 1: Verbundmaterialband
- 2: Bi-Band
- 3: Aluminium-Band
- 4: Kupfer-Band
- 5: Längsnaht
- 6: Bi-Band
- 6': Tri-Band
- 7: Manganin®-Band
- 8: Kupfer-Band
- 8': Kupfer-Band
- 9: Verbundmaterialband
- 10: Aluminium-Band
- 11: Bauelement
- 11': Bauteil
- 12: Aluminium-Teil
- 12': Aluminium-Bauteil
- 13: Aluminium-Teil
- 14: Kupfer-Bauteil
- 14': Kupfer-Bauteil
- 15: Kupfer-Bauteil
- 16: Strommesswiderstand
- 17: Verbundmaterialband
- 18: Aluminium-Band
- 19: Kupfer-Band
- 20: Manganin®-Band
- 21: Widerstandselement
- 22: Anschlussteil aus Kupfer
- 23: Anschlussteil aus Kupfer
- 24: Anschlussteil aus Kupfer
- 25: Anschlussteil aus Kupfer
- 26: Kupfer-Band
- 27: Aluminium-Stromschiene
- 28: Aluminium-Anschluss
- 29: Batterieklemme
- 30: Negativer Pol der Batterie
- 31: Batterie
- 32: Aluminium-Stromschiene
- 33: Kupfer-Stromschiene
- 34: Verschraubung
- 35: Strommesswiderstand
- 36: Verschweißung
- 37: Kupfer-Stromschiene
- 38: Aluminium-Stromschiene
- 39: Aluminium-Stromschiene
- 40: Kupfer-Stromschiene
- 41: Verschweißung
- 42: Kupfer-Stromschiene
- 43: Aluminium-Kupfer-Bauteil
- 44: Aluminium-Elektrolyt-Kondensator

## Patentansprüche

1. Verbundmaterialband (1) zur Herstellung eines elektrischen Widerstands (16; 35), insbesondere eines niederohmigen Strommesswiderstands (16; 35), mit
a) einem ersten Materialband (4), und
b) einem zweiten Materialband (3), wobei das erste Materialband (4) und das zweite Materialband (3) entlang einer Längsnaht elektrisch und mechanisch miteinander verbunden sind, und
c) ein drittes Materialband (7), wobei das dritte Materialband (7) entlang einer Längsnaht elektrisch und mechanisch mit dem ersten Materialband (4) verbunden ist,
**dadurch gekennzeichnet,**
d) **dass** das erste Materialband (4) aus einem kupferhaltigen Leitermaterial besteht zur späteren Ausbildung eines ersten Anschlussteils des elektrischen Widerstands (16; 35),
e) **dass** das zweite Materialband (3) aus einem aluminiumhaltigen Leitermaterial besteht zur späteren Ausbildung eines zweiten Anschlussteils des elektrischen Widerstands (16; 35),
f) **dass** das dritte Materialband (7) aus einem Widerstandsmaterial besteht, insbesondere aus einer Kupfer-Mangan-Nickel-Legierung, zur späteren Ausbildung eines Widerstandselements (21) des Widerstands (16; 35),
g) **dass** das Verbundmaterialband (1) ein viertes Materialband (8) aus dem kupferhaltigen Leitermaterial aufweist zur späteren Ausbildung eines dritten Anschlussteils des Widerstands, wobei das vierte Materialband (8) entlang seiner Längskante elektrisch und mechanisch mit dem dritten Materialband (7) aus dem Widerstandsmaterial verbunden ist.

2. Verbundmaterialband nach Anspruch 1, **dadurch gekennzeichnet,**
a) **dass** das aus dem kupferhaltigen Leitermaterial bestehende erste Materialband (4) durch eine Schweißverbindung mit dem aus dem Widerstandsmaterial bestehenden dritten Materialband (7) verbunden ist, insbesondere durch Elektronenstrahlschweißen, und/oder
b) **dass** das aus dem kupferhaltigen Leitermaterial bestehende vierte Materialband (8) durch eine Schweißverbindung mit dem aus dem Widerstandsmaterial bestehenden dritten Materialband (7) verbunden ist, insbesondere durch Elektronenstrahlschweißen.

3. Verbundmaterialband nach einem der vorhergehenden Ansprüche, **dadurch gekennzeichnet,**
a) **dass** das Widerstandsmaterial des Widerstandselements einen größeren spezifischen elektrischen Widerstand aufweist als das kupferhaltige Leitermaterial und als das aluminiumhaltige Leitermaterial, und/oder
b) **dass** das Widerstandsmaterial eine Kupfer-Mangan-Legierung, insbesondere eine Kupfer-Mangan-Nickel-Legierung, oder eine Nickel-Chrom-Legierung ist, und/oder
c) **dass** das aus dem Widerstandsmaterial bestehende dritte Materialband dünner ist als die anderen Materialbänder, und/oder
d) **dass** das erste Materialband (4) und das zweite Materialband (3) und das vierte Materialband (8) gleich dick sind.

4. Herstellungsverfahren zur Herstellung eines elektrischen Widerstands, insbesondere eines niederohmigen Strommesswiderstands, mit den folgenden Schritten:
a) Bereitstellen eines ersten Materialbands (4) aus einem kupferhaltigen Leitermaterial, zur späteren Ausbildung eines ersten Anschlussteils des elektrischen Widerstands,
b) Bereitstellen eines zweiten Materialbands (3) zur späteren Ausbildung eines zweiten Anschlussteils des elektrischen Widerstands, und
c) Zusammenfügen des ersten Materialbands (4) mit dem zweiten Materialbands (3) entlang einer Längsnaht zu einem Verbundmaterialband mit einer elektrischen und mechanischen Verbindung zwischen dem ersten Materialband (4) und dem zweiten Materialband (3),
d) Bereitstellen eines dritten Materialbands (7),
e) Zusammenfügen des dritten Materialbands (7) entlang einer Längsnaht mit dem ersten Materialband (4),
**dadurch gekennzeichnet,**
f) **dass** das zweite Materialband (3) aus einem aluminiumhaltigen Leitermaterial besteht,
g) **dass** das dritte Materialband (7) aus einem Widerstandsmaterial besteht, insbesondere aus einer Kupfer-Mangan-Nickel-Legierung, zur späteren Ausbildung eines Widerstandselements (21) des Widerstands (16; 35),
h) **dass** ein viertes Materialband (8) aus dem kupferhaltigen Leitermaterial bereitgestellt wird zur späteren Ausbildung eines dritten Anschlussteils des Widerstands, und
i) **dass** das vierte Materialband (8) mit dem dritten Materialband (7) entlang einer Längsnaht zusammengefügt wird.

5. Herstellungsverfahren nach Anspruch 4,
**dadurch gekennzeichnet,**
a) **dass** das aus dem kupferhaltigen Leitermaterial bestehende erste Materialband (4) durch eine Schweißverbindung mit dem aus dem Widerstandsmaterial bestehenden dritten Materialband (7) verbunden wird, insbesondere durch Elektronenstrahlschweißen, und/oder
b) **dass** das aus dem kupferhaltigen Leitermaterial bestehende vierte Materialband (8) durch eine Schweißverbindung mit dem aus dem Widerstandsmaterial bestehenden dritten Materialband (7) verbunden wird, insbesondere durch Elektronenstrahlschweißen.

6. Herstellungsverfahren nach einem der Ansprüche 4 bis 5, **gekennzeichnet durch** folgenden Schritt:
Abtrennen des elektrischen Widerstands (16; 35) von dem Verbundmaterialband (1) quer zu dem Verbundmaterialband (1),
insbesondere **durch** Stanzen.

7. Herstellungsverfahren nach Anspruch 6,
**gekennzeichnet durch** folgende Schritte:
a) Biegen des von dem Verbundmaterialband (1) abgetrennten Widerstands (16; 35) quer zur Bandlängsrichtung oder in Stromflussrichtung, und/oder
b) Justieren eines elektrischen Widerstandswerts des von dem Verbundmaterialband (1) abgetrennten Widerstands.

8. Widerstand (16; 35), insbesondere niederohmiger Strommesswiderstand (16; 35), mit
a) einem ersten Anschlussteil (22) aus einem kupferhaltigen Leitermaterial,
b) einem Widerstandselement (21) aus einem Widerstandsmaterial, wobei das Widerstandselement (21) elektrisch und mechanisch mit dem ersten Anschlussteil (22) aus dem kupferhaltigen Leitermaterial verbunden ist, und
c) einem zweiten Anschlussteil (25),
**dadurch gekennzeichnet,**
d) **dass** das zweite Anschlussteil (25) aus einem aluminiumhaltigen Leitermaterial besteht und elektrisch und mechanisch mit dem ersten Anschlussteil (22) verbunden ist, und
e) **dass** der Widerstand (16; 35) ein drittes Anschlussteil (23) aus dem kupferhaltigen Leitermaterial aufweist, wobei das dritte Anschlussteil (23) mit dem Widerstandselement (21) verbunden ist, so dass das Widerstandselement (21) im Stromflusspfad zwischen dem ersten Anschlussteil (22) und dem dritten Anschlussteil (23) angeordnet ist.

9. Widerstand (16; 35) nach Anspruch 8, **dadurch gekennzeichnet,**
a) **dass** die Anschlussteile (25, 22, 23) jeweils plattenförmig sind, und/oder
b) **dass** das Widerstandselement (21) plattenförmig ist, und/oder
c) **dass** das kupferhaltige Leitermaterial Kupfer oder eine Kupfer-Legierung ist, und/oder
d) **dass** das aluminiumhaltige Leitermaterial Aluminium oder eine Aluminiumlegierung ist, und/oder
e) **dass** das aluminiumhaltige Leitermaterial besser mit Aluminium verschweißbar ist als das erste Leitermaterial, und/oder
f) **dass** das Widerstandsmaterial eine Kupfer-Mangan-Legierung, insbesondere eine Kupfer-Mangan-Nickel-Legierung, oder eine Nickel-Chrom-Legierung ist, und/oder
g) **dass** das Widerstandsmaterial des Widerstandselements einen größeren spezifischen elektrischen Widerstand aufweist als das erste Leitermaterial und das zweite Leitermaterial, und/oder
h) **dass** der Widerstand einen Widerstandswert aufweist, der
h1) mindestens 0,1µΩ, 0,5µΩ, 1µΩ, 2µΩ, 5µΩ, 10µΩ, 20µΩ und/oder
h2) höchstens 1000µΩ, 500µΩ, 250µΩ, 100µΩ oder 50µΩ beträgt, und/oder
i) **dass** der Widerstand eine Dauerstromfestigkeit von mindestens 100A, 1kA, 2kA, 5kA oder 10kA aufweist, und/oder
j) **dass** der Widerstand eine Dicke aufweist, die mindestens 0,2mm, 0,5mm, 1mm oder 2mm und/oder höchstens 20mm, 10mm oder 5mm beträgt, und/oder
k) **dass** der Widerstand einen Widerstandswert mit einem Temperaturkoeffizienten von weniger als 500ppm/K, 200ppm/K oder 50ppm/K aufweist, und/oder
l) **dass** der Widerstand eine Induktivität von weniger als 10nH, 3nH oder 1nH aufweist, und/oder
m) **dass** die beiden Anschlussteile und das Widerstandselement (21) aus einem Verbundmaterialband quer zur Längsrichtung des Verbundmaterialbands abgetrennt und gebogen sind, und/oder
n) **dass** der Widerstand (16; 35) eine Länge in Stromflussrichtung aufweist, die größer als 10mm, 20mm, 30mm oder 40mm und/oder kleiner als 150mm, 80mm oder 70mm ist, und/oder
o) **dass** der Widerstand (16; 35) eine Breite quer zur Stromflussrichtung aufweist, die größer als 5mm, 10mm, 20mm, 30mm oder 40mm und/oder kleiner als 200mm, 150mm oder 70mm ist, und/oder
p) **dass** der Widerstand (16; 35) eine Dicke quer zur Stromflussrichtung aufweist, die größer als 0,5mm, 1mm, 2mm, 5mm oder 7mm und/oder kleiner als 30mm, 15mm oder 10mm ist, und/oder
q) **dass** das Widerstandselement (21) dünner ist als die Anschlussteile (22, 23).

10. Stromschienenanordnung mit
a) einer ersten Stromschiene (27, 32, 38) aus einem aluminiumhaltigen Leitermaterial, insbesondere aus Aluminium oder einer Aluminium-Legierung, und
b) einem Widerstand (35) nach einem der Ansprüche 8 bis 9,
c) wobei das aus dem aluminiumhaltigen Leitermaterial bestehende zweite Anschlussteil des Widerstands (35) elektrisch und mechanisch mit der ersten Stromschiene (27, 32, 38) verbunden ist, insbesondere durch eine Schraubverbindung, eine Nietverbindung oder eine Verschweißung.

11. Stromschienenanordnung nach Anspruch 10,
**dadurch gekennzeichnet,**
a) **dass** eine zweite Stromschiene (33) aus einem kupferhaltigen Leitermaterial vorgesehen ist, und
b) **dass** der Widerstand (35) mit seinem dritten Anschlussteil aus dem kupferhaltigen Leitermaterial die zweite Stromschiene aus dem kupferhaltigen Leitermaterial kontaktiert.

12. Stromschienenanordnung nach Anspruch 10,
**dadurch gekennzeichnet,**
a) **dass** ein Kondensator (44) vorgesehen ist, insbesondere ein Aluminium-Elektrolyt-Kondensator, mit Kontaktzungen aus einem aluminiumhaltigen Leitermaterial, und
b) **dass** mindestens eine der aus dem aluminiumhaltigen Leitermaterial bestehenden Kontaktzungen des Kondensators (44) mit der aus dem aluminiumhaltigen Leitermaterial bestehenden ersten Stromschiene (43) verbunden ist.

## Claims

1. Composite material strip (1) for producing an electric resistor (16; 35), in particular a low-resistance current-measuring resistor (16; 35), with
a) a first material strip (4), and
b) a second material strip (3), wherein the first material strip (4) and the second material strip (3) are connected together electrically and mechanically along a longitudinal seam,
c) a third material strip (7), wherein the third material strip (7) is connected electrically and mechanically along a longitudinal seam to the first material strip (4),
**characterised in**
d) **that** the first material strip (4) is made of a copper-containing conductor material for later formation of a first connecting part of the electric resistor (16; 35),
e) **that** the second material strip (3) consists of an aluminium-containing conductor material for later formation of a second connecting part of the electric resistor (16; 35),
f) **that** the third material strip (7) is made of a resistance material, in particular a copper-manganese-nickel alloy, for later formation of a resistor element (21) of the resistor (16; 35),
g) **that** the composite material strip (1) comprises a fourth material strip (8) made of the copper-containing conductor material for later formation of a third connecting part of the resistor, wherein the fourth material strip (8) is connected electrically and mechanically along its longitudinal edge to the third material strip (7) made of the resistance material.

2. Composite material strip according to claim 1, **characterised in**
a) **that** the first material strip (4) made of the copper-containing conductor material is connected to the third material strip (7) made of resistance material by means of a weld connection, in particular by electron beam welding, and/or
b) **that** the fourth material strip (8) made of the copper-containing conductor material is connected to the third material strip (7) made of resistance material by means of a weld connection, in particular by electron beam welding.

3. Composite material strip according to any of the preceding claims, **characterised in**
a) **that** the resistance material of the resistor element has a greater specific electrical resistance than the copper-containing conductor material and the aluminium-containing conductor material, and/or
b) **that** the resistance material is a copper-manganese alloy, in particular a copper-manganese-nickel alloy or a nickel-chromium alloy, and/or
c) **that** the third material strip made of the resistance material is thinner than the other material strips, and/or
d) **that** the first material strip (4) and the second material strip (3) and the fourth material strip (8) have the same thickness.

4. Production method for producing an electrical resistor, in particular a low-resistance current-measuring resistor, with the following steps:
a) provision of a first material strip (4) made of a copper-containing conductor material, for later formation of a first connecting part of the electric resistor,
b) provision of a second material strip (3) for later formation of a second connecting part of the electric resistor, and
c) joining of the first material strip (4) to the second material strip (3) along a longitudinal seam to form a composite material strip with an electrical and mechanical connection between the first material strip (4) and the second material strip (3),
d) provision of a third material strip (7),
e) joining of the third material strip (7) to the first material strip (4) along a longitudinal seam,
**characterised in**
f) **that** the second material strip (3) is made of an aluminium-containing conductor material,
g) **that** the third material strip (7) is made of a resistance material, in particular a copper-manganese-nickel alloy, for later formation of a resistor element (21) of the resistor (16; 35),
h) **that** a fourth material strip (8) made of the copper-containing conductor material is provided for later formation of a third connecting part of the resistor, and
i) **that** the fourth material strip (8) is connected electrically and mechanically along a longitudinal seam to the third material strip (7).

5. Production method according to claim 4, **characterised in**
a) **that** the first material strip (4) made of the copper-containing conductor material is connected to the third material strip (7) made of the resistance material by means of a weld connection, in particular by electron beam welding, and/or
b) **that** the fourth material strip (8) made of the copper-containing conductor material is connected to the third material strip (7) made of the resistance material by means of a weld connection, in particular by electron beam welding.

6. Production method according to any of claims 4 to 5, **characterised by** the following step:
cutting-off of the electrical resistor (16; 35) from the composite material strip (1) transversely to the composite material strip (1), in particular by punching.

7. Production method according to claim 6, **characterised by** the following steps:
a) bending of the resistor (16; 35) cut from the composite material strip (1) transversely to the strip longitudinal direction or in the current flow direction, and/or
b) adjustment of an electrical resistance value of the resistor cut from the composite material strip (1).

8. Resistor (16; 35), in particular a low-resistance current-measuring resistor (16; 35), with
a) a first connecting part (22) made of a copper-containing conductor material,
b) a resistor element (21) made of a resistance material, wherein the resistor element (21) is electrically and mechanically connected to the first connecting part (22) made of the copper-containing conductor material, and
c) a second connecting part (25),
**characterised in**
d) **that** the second connecting part (25) consists of an aluminium-containing conductor material, and is connected electrically and mechanically to the first connecting part (22), and
e) **that** the resistor (16; 35) comprises a third connecting part (23) made of the copper-containing conductor material, wherein the third connecting part (23) is connected to the resistor element (21), so that the resistor element (21) is arranged in the current flow path between the first connecting part (22) and the third connecting part (23).

9. Resistor (16; 35) according to claim 8,
**characterised in**
a) **that** the connecting parts (25, 22, 23) are each plate-shaped, and/or
b) **that** the resistor element (21) is plate-shaped, and/or
c) **that** the copper-containing conductor material is copper or a copper alloy, and/or
d) **that** the aluminium-containing conductor material is aluminium or an aluminium alloy, and/or
e) **that** the aluminium-containing conductor material can be welded better to aluminium than the first conductor material, and/or
f) **that** the resistance material is a copper-manganese alloy, in particular a copper-manganese-nickel alloy, or a nickel-chromium alloy, and/or
g) **that** the resistance material of the resistor element has a greater specific electrical resistance than the first conductor material and the second conductor material, and/or
h) **that** the resistor has a resistance value which
h1) is at least 0.1µΩ, 0.5µΩ, 1µΩ, 2µΩ, 5µΩ, 10µΩ, 20µΩ and/or
h2) is at most 1000µΩ, 500µΩ, 250µΩ, 100µΩ or 50µΩ, and/or
i) **that** the resistor has a steady current strength of at least 100A, 1kA, 2kA, 5kA or 10kA, and/or
j) **that** the resistor has a thickness which is at least 0.2mm, 0.5mm, 1mm or 2mm and/or at most 20mm, 10mm or 5mm, and/or
k) **that** the resistor has a resistance value with a temperature coefficient of less than 500ppm/K, 200ppm/K or 50ppm/K, and/or
l) **that** the resistor has an inductance of less than 10nH, 3nH or 1nH, and/or
m) **that** the two connecting parts and the resistor element (21) are cut from a composite material strip transversely to the longitudinal direction of the composite material strip, and then bent, and/or
n) **that** the resistor (16; 35) has a length in the current flow direction which is greater than 10mm, 20mm, 30mm or 40mm and/or less than 150mm, 80mm or 70mm, and/or
o) **that** the resistor (16; 35) has a width transversely to the current flow direction which is greater than 5mm, 10mm, 20mm, 30mm or 40mm and/or less than 200mm, 150mm or 70mm, and/or
p) **that** the resistor (16; 35) has a thickness transversely to the current flow direction which is greater than 0.5mm, 1mm, 2mm, 5mm or 7mm and/or less than 30mm, 15mm or 10mm, and/or
q) **that** the resistor element (21) is thinner than the connecting parts (22, 23).

10. Conductor rail arrangement with
a) a first conductor rail (27, 32, 38) made of an aluminium-containing conductor material, in particular aluminium or an aluminium alloy, and
b) a resistor (35) according to any of claims 8 to 9,
c) wherein the second connecting part of the resistor (35), consisting of the aluminium-containing conductor material, is connected electrically and mechanically to the first conductor rail (27, 32, 38), in particular by a screw connection, a rivet connection or by welding.

11. Conductor rail arrangement according to claim 10, **characterised in**
a) **that** a second conductor rail (33) made of a copper-containing conductor material is provided, and
b) **that** the resistor (35) with its third connecting part made of the copper-containing conductor material contacts the second conductor rail made of the copper-containing conductor material.

12. Conductor rail arrangement according to claim 10, **characterised in**
a) **that** a capacitor (44) is provided, in particular an aluminium electrolyte capacitor, with contact tabs made of an aluminium-containing conductor material, and
b) **that** at least one of the contact tabs of the capacitor (44) made of the aluminium-containing conductor material is connected to the first conductor rail (43) made of the aluminium-containing conductor material.

## Revendications

1. Bande de matériau composite (1) pour fabriquer une résistance électrique (16 ; 35), en particulier une résistance de mesure de courant (16 ; 35) de basse impédance, avec
a) une première bande de matériau (4), et
b) une deuxième bande de matériau (3), dans laquelle la première bande de matériau (4) et la deuxième bande de matériau (3) sont reliées l'une à l'autre de manière électrique et de manière mécanique le long d'un cordon de soudure longitudinal, et
c) une troisième bande de matériau (7), dans laquelle la troisième bande de matériau (7) est reliée de manière électrique et de manière mécanique à la première bande de matériau (4) le long d'un cordon de soudure longitudinal,
**caractérisée en ce**
d) **que** la première bande de matériau (4) est constituée d'un matériau conducteur contenant du cuivre pour réaliser ultérieurement une première partie de raccordement de la résistance électrique (16 ; 35),
e) **que** la deuxième bande de matériau (3) est constituée d'un matériau conducteur contenant de l'aluminium pour réaliser ultérieurement une deuxième partie de raccordement de la résistance électrique (16 ; 35),
f) **que** la troisième bande de matériau (7) est constituée d'un matériau de résistance, en particulier d'un alliage de cuivre-manganèse-nickel pour réaliser ultérieurement un élément de résistance (21) de la résistance (16 ; 35),
g) **que** la bande de matériau composite (1) présente une quatrième bande de matériau (8) composée du matériau conducteur contenant du cuivre pour réaliser ultérieurement une troisième partie de raccordement de la résistance, dans laquelle la quatrième bande de matériau (8) est reliée de manière électrique et de manière mécanique à la troisième bande de matériau (7) composée du matériau de résistance le long de son arête longitudinale.

2. Bande de matériau composite selon la revendication 1, **caractérisée en ce**
a) **que** la première bande de matériau (4) constituée du matériau conducteur contenant du cuivre est reliée à la troisième bande de matériau (7) constituée du matériau de résistance par une liaison par soudage, en particulier par soudage par faisceau d'électrons, et/ou
b) **que** la quatrième bande de matériau (8) constituée du matériau conducteur contenant du cuivre est reliée à la troisième bande de matériau (7) constituée du matériau de résistance par une liaison par soudage, en particulier par soudage par faisceau d'électrons.

3. Bande de matériau composite selon l'une quelconque des revendications précédentes, **caractérisée en ce**
a) **que** le matériau de résistance de l'élément de résistance présente une résistance électrique spécifique plus grande que le matériau conducteur contenant du cuivre et que le matériau conducteur contenant de l'aluminium, et/ou
b) **que** le matériau de résistance est un alliage de cuivre-manganèse, en particulier un alliage de cuivre-manganèse-nickel ou un alliage de nickel-chrome, et/ou
c) **que** la troisième bande de matériau constituée du matériau de résistance est plus fine que les autres bandes de matériau, et/ou
d) **que** la première bande de matériau (4) et la deuxième bande de matériau (3) et la quatrième bande de matériau (8) présentent la même épaisseur.

4. Procédé de fabrication pour fabriquer une résistance électrique, en particulier une résistance de mesure de courant de faible impédance, avec les étapes suivantes :
a) de fourniture d'une première bande de matériau (4) composée d'un matériau conducteur contenant du cuivre pour réaliser ultérieurement une première partie de raccordement de la résistance électrique,
b) de fourniture d'une deuxième bande de matériau (3) pour réaliser ultérieurement une deuxième partie de raccordement de la résistance électrique, et
c) d'assemblage de la première bande de matériau (4) à la deuxième bande de matériau (3) le long d'un cordon de soudure longitudinal pour former une bande de matériau composite avec une liaison électrique et mécanique entre la première bande de matériau (4) et la deuxième bande de matériau (3),
d) de fourniture d'une troisième bande de matériau (7),
e) d'assemblage de la troisième bande de matériau (7) le long d'un cordon de soudure longitudinal à la première bande de matériau (4),
**caractérisé en ce**
f) **que** la deuxième bande de matériau (3) est constituée d'un matériau conducteur contenant de l'aluminium,
g) **que** la troisième bande de matériau (7) est constituée d'un matériau de résistance, en particulier d'un alliage de cuivre-manganèse-nickel, pour réaliser ultérieurement un élément de résistance (21) de la résistance (16 ; 35),
h) **qu'**une quatrième bande de matériau (8) composée du matériau conducteur contenant du cuivre est fournie pour réaliser ultérieurement une troisième partie de raccordement de la résistance, et
i) **que** la quatrième bande de matériau (8) est assemblée à la troisième bande de matériau (7) le long d'un cordon de soudure longitudinal.

5. Procédé de fabrication selon la revendication 4,
**caractérisé en ce**
a) **que** la première bande de matériau (4) constituée du matériau conducteur contenant du cuivre est reliée à la troisième bande de matériau (7) constituée du matériau de résistance par une liaison par soudage, en particulier par soudage par faisceau d'électrons, et/ou
b) **que** la quatrième bande de matériau (8) constituée du matériau conducteur contenant du cuivre est reliée à la troisième bande de matériau (7) constituée du matériau de résistance par une liaison par soudage, en particulier par soudage par faisceau d'électrons.

6. Procédé de fabrication selon l'une quelconque des revendications 4 à 5, **caractérisé par** l'étape suivante :
de séparation de la résistance électrique (16 ; 35) de la bande de matériau composite (1) de manière transversale par rapport à la bande de matériau composite (1), en particulier par découpage.

7. Procédé de fabrication selon la revendication 6, **caractérisé par** des étapes suivantes :
a) de cintrage de la résistance (16 ; 35) séparée de la bande de matériau composite (1) de manière transversale par rapport au sens longitudinal de bande ou dans le sens de flux de courant, et/ou
b) d'ajustement d'une valeur de résistance électrique de la résistance séparée de la bande de matériau composite (1).

8. Résistance (16 ; 35), en particulier résistance de mesure de courant (16 ; 35) de faible impédance, avec
a) une première partie de raccordement (22) composée d'un matériau conducteur contenant du cuivre,
b) d'un élément de résistance (21) composé d'un matériau de résistance, dans laquelle l'élément de résistance (21) est relié de manière électrique et de manière mécanique à la première partie de raccordement (22) composée du matériau conducteur contenant du cuivre, et
c) une deuxième partie de raccordement (25), **caractérisée en ce**
d) **que** la deuxième partie de raccordement (25) est constituée d'un matériau conducteur contenant de l'aluminium et est reliée de manière électrique et de manière mécanique à la première partie de raccordement (22), et
e) **que** la résistance (16 ; 35) présente une troisième partie de raccordement (23) composée du matériau conducteur contenant du cuivre, dans laquelle la troisième partie de raccordement (23) est reliée à l'élément de résistance (21) de telle sorte que l'élément de résistance (21) est disposé dans le trajet de flux de courant entre la première partie de raccordement (22) et la troisième partie de raccordement (23).

9. Résistance (16 ; 35) selon la revendication 8, **caractérisée en ce**
a) **que** les parties de raccordement (25, 22, 23) sont respectivement en forme de plaque, et/ou
b) **que** l'élément de résistance (21) est en forme de plaque, et/ou
c) **que** le matériau conducteur contenant du cuivre est du cuivre ou un alliage de cuivre, et/ou
d) **que** le matériau conducteur contenant de l'aluminium est de l'aluminium ou un alliage d'aluminium, et/ou
e) **que** le matériau conducteur contenant de l'aluminium peut être mieux assemblé par soudage à l'aluminium que le premier matériau conducteur, et/ou
f) **que** le matériau de résistance est un alliage de cuivre-manganèse, en particulier un alliage de cuivre-manganèse-nickel, ou un alliage de nickel-chrome, et/ou
g) **que** le matériau de résistance de l'élément de résistance présente une résistance électrique spécifique plus importante que le premier matériau conducteur et le deuxième matériau conducteur, et/ou
h) **que** la résistance présente une valeur de résistance, qui est
h1) d'au moins 0,1µΩ, 0,5 µΩn 1 µΩ, 2 µΩ, 5 µΩ, 10 µΩ, 20 µΩ et/ou
h2) au maximum de 1000 µΩ, 500 µΩ, 250 µΩ, 100 µΩ ou de 50 µΩ, et/ou
i) **que** la résistance présente une résistance de courant permanent d'au moins 100 A, 1 kA, 2 kA, 5 kA ou 10 kA, et/ou
j) **que** la résistance présente une épaisseur qui est d'au moins 0,2 mm, 0,5 mm, 1 mm ou 2 mm et/ou au maximum de 20 mm, 10 mm ou de 5 mm, et/ou
k) **que** la résistance présente une valeur de résistance avec un coefficient de température inférieur à 500 ppm/K, 200 ppm/K ou 50 ppm/K, et/ou
l) **que** la résistance présente une inductance inférieure à 10 nH, 3 nH ou 1 nH, et/ou
m) **que** les deux parties de raccordement et l'élément de résistance (21) composés d'une bande de matériau composite sont séparés et cintrés de manière transversale par rapport au sens longitudinal de la bande de matériau composite, et/ou
n) **que** la résistance (16 ; 35) présente une longueur dans le sens de flux de courant qui est supérieure à 10 mm, 20 mm, 30 mm ou 40 mm et/ou inférieure à 150 mm, 80 mm ou 70 mm, et/ou
o) **que** la résistance (16 ; 35) présente une largeur de manière transversale par rapport au sens de flux de courant qui est supérieure à 5 mm, 10 mm, 20 mm, 30 mm ou 40 mm et/ou inférieure à 200 mm, 150 mm ou 70 mm, et/ou
p) **que** la résistance (16 ; 35) présente une épaisseur de manière transversale par rapport au sens de flux de courant, qui est supérieure à 0,5 mm, 1 mm, 2 mm, 5 mm ou 7 mm et/ou inférieure à 30 mm, 15 mm ou 10 mm, et/ou
q) **que** l'élément de résistance (21) est plus fin que les parties de raccordement (22, 23).

10. Ensemble de barres omnibus avec
a) une première barre omnibus (27, 32, 38) composée d'un matériau conducteur contenant de l'aluminium, en particulier composée d'aluminium ou d'un alliage d'aluminium, et
b) une résistance (35) selon l'une quelconque des revendications 8 à 9,
c) dans lequel la deuxième partie de raccordement, constituée du matériau conducteur contenant de l'aluminium, de la résistance (35) est reliée de manière électrique et mécanique à la première barre omnibus (27, 32, 38), en particulier par une liaison par vissage, une liaison par rivetage ou un assemblage par soudage.

11. Ensemble de barres omnibus selon la revendication 10,
**caractérisé en ce**
a) **qu'**une deuxième barre omnibus (33) composée d'un matériau conducteur contenant du cuivre est prévue, et
b) **que** la résistance (35) établit un contact par sa troisième partie de raccordement composée du matériau conducteur contenant du cuivre avec la deuxième barre omnibus composée du matériau conducteur contenant du cuivre.

12. Ensemble de barres omnibus selon la revendication 10,
**caractérisé en ce**
a) **qu'**un condensateur (44) est prévu, en particulier un condensateur électrolyte-aluminium, avec des languettes de contact composées d'un matériau conducteur contenant de l'aluminium, et
b) **qu'**au moins une des languettes de contact constituées du matériau conducteur contenant de l'aluminium du condensateur (44) est reliée à la première barre omnibus (43) constituée du matériau conducteur contenant de l'aluminium.
